# EUROPÄISCHE PATENTANMELDUNG

(11) **EP 1 843 230 A1**
(43) Veröffentlichungstag der Anmeldung: **10.10.2007**
(21) Anmeldenummer: 06007401.0
(22) Anmeldetag: 07.04.2006
(51) Int. Cl.: G05B 19/409, H02B 15/00, H03M 7/30, H03M 1/12

(54) **Verfahren und Vorrichtung zum Erfassen von Werten eines Signals**

(71) Anmelder: SIEMENS AKTIENGESELLSCHAFT, 80333 München (DE)
(72) Erfinder: Bode, Andreas, 91315 Höchstadt A.D. Aisch (DE)

(57) **Zusammenfassung**

Die vorliegende Erfindung betrifft ein Verfahren und eine Vorrichtung zur Verringerung der Menge der abzuspeichernden Werte (19-22) eines abgetasteten Signals (18). Ein Wert des Signals (18) wird gespeichert, wenn der Wert (19-22) außerhalb oder an der Grenze eines vorgegebenen Wertebereichs (23-25) liegt, dessen Größe durch einen oberen Grenzwert (27,30,34) und einen unteren Grenzwert (28,31,33) bestimmt ist. Erfindungsgemäß wird die Größe des Wertebereichs (23-25) ausgehend von einer vorgegebenen Anfangsgröße (26,29,32) des Wertebereichs während des Erfassens der Werte verändert, insbesondere stetig bis auf Null verkleinert.

## Beschreibung

Die vorliegende Erfindung betrifft ein Verfahren zum Erfassen von Werten eines Signals, bei dem ein Wert des Signals gespeichert wird, wenn der Wert außerhalb oder an der Grenze eines vorgegebenen Wertebereichs liegt, dessen Größe durch einen oberen Grenzwert und einen unteren Grenzwert bestimmt ist. Die vorliegende Erfindung betrifft ferner eine Vorrichtung zum Erfassen von Werten eines Signals, wobei die Vorrichtung ein Steuermittel aufweist, dass so ausgestaltet ist, dass es einen Wert des Signals abspeichert, wenn der Wert außerhalb oder an der Grenze eines vorgegebenen Wertebereichs liegt, dessen Größe durch einen oberen Grenzwert und einen unteren Grenzwert bestimmt ist.

Beim Erfassen von Werten eines Signals oder beim Abtasten eines Signals soll bei vielen Anwendungen die Menge der abzuspeichernden Werte oder Daten des Signals begrenzt werden, um den dazu nötigen Speicherbedarf gering zu halten. Kompressionsverfahren erlauben dies. Die abgespeicherte Werte- oder Datenmenge wird reduziert oder gering gehalten, ohne wichtige, in den erfassten und abgespeicherten Werten enthaltene Informationen über das Signal zu verlieren. Dabei sollen üblicherweise schnelle Änderungen des Signals zeitnah, genaue Werte bei kleinen Änderungen und in dem Signal enthaltene Strukturen, wie z. B. Driften, Rampen und Rauschen, aufgezeichnet werden.

Bei bekannten Lösungen erfolgt beim Erfassen von Werten des Signals ein Abspeichern von Werten in festen zeitlichen Abständen. Zudem werden in einem bestimmten Wertebereich liegende Werte nicht abgespeichert. Dadurch soll die Anzahl der abgespeicherten Werte gering gehalten werden, indem nur Änderungen des Signals abgespeicherte werden, die eine durch den Wertebereich vorgegebene Mindeständerung überschreiten. Die Größe des Wertebereichs ist durch einen oberen und einen unteren Grenzwert festgelegt. Die Größe des Wertebereichs bleibt über den gesamten Verlauf des Erfassens der Werte konstant. Ein Speichern eines neuen Wertes erfolgt somit dann, wenn der neue Wert von einem vorhergehenden Wert mindestens um den oberen oder den unteren Grenzwert abweicht. Das Speichern erfolgt dann, wenn der neue abzuspeichernde Wert außerhalb des vorgegebenen Wertebereichs liegt. Ein solcher Wertebereich wird auch als Totband bezeichnet.

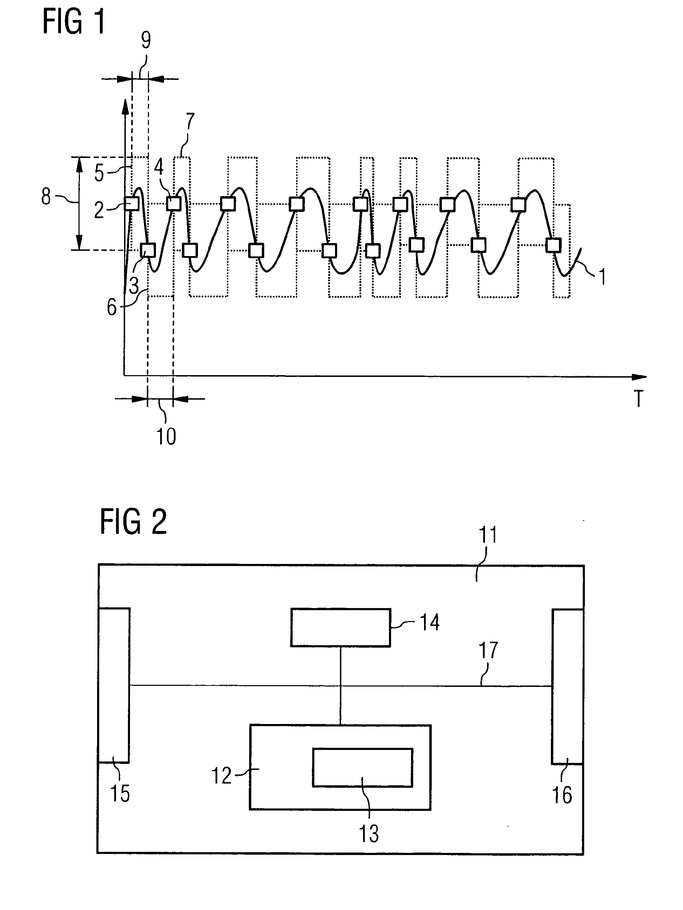

Fig. 1 zeigt ein Beispiel eines verrauschten, im Wesentlichen sinusförmigen Signals 1. In der Fig. 1 ist ein Koordinatensystem dargestellt, in dem der Verlauf des Signals 1 über der Zeit aufgetragen ist. Das Signal 1 wird in der oben beschriebenen herkömmlichen Weise abgetastet. Dabei werden Werte des Signals 1 erfasst und abgespeichert. In der Fig. 1 sind die abgespeicherten Werte mit einer quadratischen Markierung versehen. Beispielhaft sind im Verlauf des Signals 1 erfasste und abgespeicherte Werte 2, 3 und 4 näher bezeichnet. Das Abspeichern der Werte erfolgt mittels vorgegebener Wertebereiche. In der Fig. 1 sind die Wertebereiche gepunktet dargestellt. In der Fig. 1 sind Wertebereiche 5, 6 und 7 näher bezeichnet. In ihrer zeitlichen Ausdehnung beschreiben die Wertebereiche rechteckige Flächen. Die Größen der Wertebereiche sind durch ihre Ausdehnungen in vertikaler, d. h. in Ordinatenrichtung, angegeben. Wie in der Fig. 1 zu erkennen ist, sind die Größen der Wertebereiche über ihren zeitlichen Verlauf jeweils gleich. In der Fig. 1 sind die Größen der Wertebereiche 5-7 mit einem Bezugszeichen 8 versehen. Die jeweilige zeitliche Ausdehnung der einzelnen Wertebereiche wird durch den Verlauf des Signals 1 bestimmt. Die zeitliche Ausbreitung der jeweiligen Wertebereiche kann unterschiedlich sein. Ein abgespeicherter Wert des Signals bestimmt die Lage des nächsten Wertebereichs. Der obere und der untere Grenzwert des nächsten Wertebereichs wird symmetrisch um den abgespeicherten Wert festgelegt. Der obere Grenzwert ist daher nach oben, d. h. in positiver Ordinatenrichtung, gleich weit von dem gespeicherten Wert entfernt, wie der untere Grenzwert nach unten, d. h. in negativer Ordinatenrichtung. In der Fig. 1 ist der Wertebereich 5 symmetrisch um den Wert 2 gelegt. Das Signal 1 wird im Beispiel nach Fig. 1 solange mit dem Wertebereich 5 abgetastet, bis ein Wert erfasst wird, der außerhalb oder an der Grenze des Wertebereichs 5 liegt. Dies ist bei dem Wert 3 in der Fig. 1 der Fall. Der Wert 3 wird somit abgespeichert. Die zeitliche Ausbreitung des Wertebereichs 5 ist in der Fig. 1 mit einem Bezugszeichen 9 bezeichnet. Die Lage des Wertes 3 dient nun als Ausgangspunkt für den nachfolgenden Wertebereich 6. Der obere und untere Grenzwert des Wertebereichs 6 werden symmetrisch zu dem Wert 3 festgelegt. Das Signal 1 wird solange mit dem Wertebereich 6 abgetastet, bis ein Wert erfasst wird, der außerhalb oder an der Grenze des Wertebereichs 6 liegt. Dies ist bei dem Wert 4 der Fall. Der Wert 4 wird abgespeichert. Die zeitliche Ausbreitung des Wertebereichs 6 ist in der Fig. 1 mit einem Bezugszeichen 10 bezeichnet. Der Wert 4 dient als Ausgangspunkt für den nächsten Wertebereich 7. Das weitere Abtasten und Erfassen des Signals 1 und das Abspeichern von weiteren Werten des Signals 1 erfolgen dann auf die gleiche Weise, wie im Zusammenhang mit den Werten 2-4 und den Wertebereichen 5-7 beschrieben.

Bei dieser Vorgehensweise zum Erfassen von Werten eines Signals tritt das Problem auf, dass zum Erfassen von insbesondere kleinen Signaländerungen die konstante Größe des Wertebereichs sehr klein eingestellt werden muss. Bei einem stark verrauschten Signal, wie beispielsweise demjenigen nach Fig. 1, ist dann entweder die Kompressionsrate unbefriedigend, d. h. es werden viele Daten abgespeichert, so dass der dafür notwendige Speicherbedarf sehr groß ist, oder der Signalsverlauf ist durch die abgespeicherten Werte nicht ausreichend genau abgebildet. Des Weiteren müssen bereits vor dem Einstellen des Wertebereichs Parameter zum Erfassen der Werte des Signals berücksichtigt werden, obwohl die abzubildenden Signalstrukturen nicht bekannt sind. Dies kann ebenfalls zu unzureichenden Ergebnissen beim Komprimieren führen.

Der vorliegenden Erfindung liegt die Aufgabe zugrunde, ein Erfassen von Werten eines Signals zu ermöglichen, so dass eine Anzahl von abgespeicherten Werten gering gehalten und die Struktur des Signals durch die abgespeicherten Werte ausreichend genau wiedergegeben wird.

Diese Aufgabe ist durch die technische Lehre des Anspruchs 1 oder des Anspruchs 12 gelöst.

Verfahrensseitig wird die Größe des Wertebereichs ausgehend von einer vorgegebenen Anfangsgröße des Wertebereichs während des Erfassens der Werte verändert. Vorrichtungsseitig ist das Steuermittel ferner so ausgestaltet, dass es die Größe des Wertebereichs während des Erfassens der Werte ausgehend von einer vorgegebenen Anfangsgröße verändert. Erfindungsgemäß wird somit der Wertebereich während des Erfassens der Werte dynamisch festgelegt. Der Wertebereich wird auch als Totband bezeichnet. Das Totband ist hier variabel. Dadurch wird eine mitunter deutliche Reduktion der Menge von abgespeicherten Werten bei gleichzeitig guter Abbildung des Verlaufs des Signals durch die abgespeicherten Werte gewährleistet.

In einer vorteilhaften Ausgestaltung der Erfindung nimmt die Größe des Wertebereichs nach einer Veränderung erneut die Anfangsgröße an, wenn ein Wert abgespeichert wurde. Dadurch können große Signaländerungen sehr schnell erkannt werden.

In einer weiteren, besonders vorteilhaften Ausgestaltung wird die Größe des Wertebereichs, insbesondere stetig, verkleinert. Dadurch ist es möglich, eine große Signaländerung schnell, insbesondere unmittelbar, und zusätzlich ebenfalls kleine Signaländerungen festzustellen. Langsame Signaldriften und Rampen werden als solche erkannt und aufgezeichnet. Ferner kann ein stark verrauschtes Signal als solches erkannt werden, ohne dass viele Werte des verrauschten Signals abgespeichert werden. Selbst in einem verrauschten Signal sind Signalspitzen schnell zu erkennen. Eine mittlere Signaländerung kann vorteilhafterweise umso eher erkannt werden, desto stärker sie ist.

Vorteilhafterweise wird ein Wert auch dann gespeichert, wenn beim Verkleinern des Wertebereichs eine vorgegebene Minimalgröße des Wertebereichs erreicht wird und noch kein außerhalb oder an der Grenze des verkleinerten Wertebereichs liegender Wert des Signals erfasst wurde. Dadurch wird sichergestellt, dass auch bei der vorgegebenen Minimalgröße ein Wert unabhängig davon, ob er innerhalb des Wertebereichs liegt, abgespeichert wird. Dadurch kann der tatsächliche Signalverlauf und seine Änderungen noch besser in den abgespeicherten Werten abgebildet werden.

Besonders bevorzugt beträgt die vorgegebene Minimalgröße des Wertebereichs Null. In diesem Fall ist ein Totband oder ein Wertebereich bei Vorliegen der Minimalgröße nicht mehr vorhanden. Der exakte Wert des Signals wird somit abgespeichert.

In einer vorteilhaften Ausgestaltung erfolgt beim Verändern der Größe des Wertebereichs ein symmetrisches Ändern des oberen Grenzwerts und des unteren Grenzwerts. Sowohl der obere als auch der untere Grenzwert werden daher in gleicher Weise verändert.

In einer weiteren vorteilhaften Ausgestaltung erfolgt das Verändern der Größe des Wertebereichs nach einer linearen Funktion. Dies gewährleistet einen besonders guten Kompromiss zwischen dem schnellen und dem genauen Erfassen und Abspeichern von Signaländerungen.

Vorzugsweise wird der Wertebereich in Abhängigkeit von einem, insbesondere unmittelbar, zuvor abgespeicherten Wert des Signals festgelegt. Dies gewährleistet ebenfalls ein schnelles und gleichzeitig genaues Erfassen und Abspeichern von Signaländerungen.

Besonders vorteilhaft wird der Wertebereich in Abhängigkeit von einem prognostizierten Wert festgelegt, der aufgrund der bisher erfassten Werte des Signals bestimmt wird. Diese Ausgestaltung der Erfindung gewährleistet ein besonders exaktes Abstimmen des Wertebereichs auf den Signalverlauf. Signaländerungen werden besonders gut, exakt und schnell erfasst.

Vorzugsweise ist eine insbesondere maximale Anzahl von in einem vorgegebenen ersten Zeitbereich des Signals zu speichernden Werten vorgegeben. Dadurch kann gewährleistet werden, dass der zum Abspeichern von Werten des Signals erforderliche Speicherbereich genau festgelegt und ausgenutzt wird. Der erste Zeitbereich kann beispielsweise eine bestimmte Zeit des Signalsverlaufs umfassen, in der regelmäßig Abspeicherungen von Werten vorgenommen werden. Beispielsweise kann somit eine gewünschte mittlere Anzahl von abzuspeichernden Werten angegeben werden.

Des Weiteren vorzugsweise wird die Anfangsgröße des Wertebereichs in Abhängigkeit von während eines vorgegebenen zweiten Zeitbereichs des Signals abgespeicherten Werten festgelegt. Der zweite Zeitbereich kann beispielsweise eine bestimmte Anzahl von Betrachtungszyklen für das Erfassen der Werte sein. Die Anfangsgröße kann vorteilhafterweise an den bisher erfassten und abgespeicherten Signalverlauf angepasst werden. Dies ermöglicht ein noch besseres und schnelleres Erfassen von Signaländerungen.

Nachfolgend werden die Erfindung und ihre Vorteile anhand von Beispielen und Ausführungsbeispielen und der beigefügten Zeichnung näher erläutert. Es zeigen:
- Fig. 1: ein Beispiel eines Erfassens von Werten eines Signals nach dem Stand der Technik,
- Fig. 2: ein Ausführungsbeispiel einer erfindungsgemäßen Vorrichtung zum Erfassen von Werten eines Signals,
- Fig. 3: ein Ausführungsbeispiel eines Erfassens von Werten bei einem stark verrauschten Signal,
- Fig. 4: ein Ausführungsbeispiel eines Erfassens von Werten bei einer Signalspitze in einem verrauschten Signal,
- Fig. 5: ein Ausführungsbeispiel eines Erfassens von Werten bei einem schwach verrauschten Signal,
- Fig. 6: ein Ausführungsbeispiel eines Erfassens von Werten bei einem schwach driftenden Signal und
- Fig. 7: ein Ausführungsbeispiel eines Erfassens von Werten bei einer starken Änderung eines Signals.

Fig. 2 zeigt ein Ausführungsbeispiel einer erfindungsgemäßen Vorrichtung 11 zum Erfassen von Werten eines Signals. Die Vorrichtung 11 enthält ein Steuermittel 12 mit einem Programmspeicher 13, einen Datenspeicher 14, eine Eingangsschnittstelle 15 und eine Ausgangsschnittstelle 16. Diese Komponenten der Vorrichtung sind über einen Bus 17 miteinander verbunden. Über die Eingangsschnittstelle 15 wird der Vorrichtung 11 ein Signal zugeleitet, das abgetastet werden soll und dessen Werte erfasst werden sollen. Dabei sollen Werte des Signals in dem Datenspeicher 14 abgespeichert werden, wenn die Werte eine Grenze eines festgelegten Wertebereichs erreichen oder überschreiten. Eine Änderung des Signals im Vergleich zu einem zuvor erfassten und gespeicherten Wert soll dadurch festgestellt und abgespeichert werden. Dabei soll die Änderung gegebenenfalls genügend groß sein, um die Menge an abzuspeichernden Werten gering zu halten, und dennoch gegebenenfalls genügend klein sein, um ein genaues Abbild des Signals mit seinen Strukturen in den gespeicherten Werten festzuhalten. Dazu wird das Signal dem Steuermittel 12 zugeführt, das das Signal entsprechend verarbeitet. Parameter zum Verarbeiten des Signals, insbesondere zum Festlegen des Wertebereichs und seiner Größe, werden dem Steuermittel 12 ebenfalls über die Eingangsschnittstelle 15 zugeleitet. Diese Parameter zusammen mit einem in dem Programmspeicher 13 abgespeicherten Programm steuern das Steuermittel 12 in geeigneter Weise.

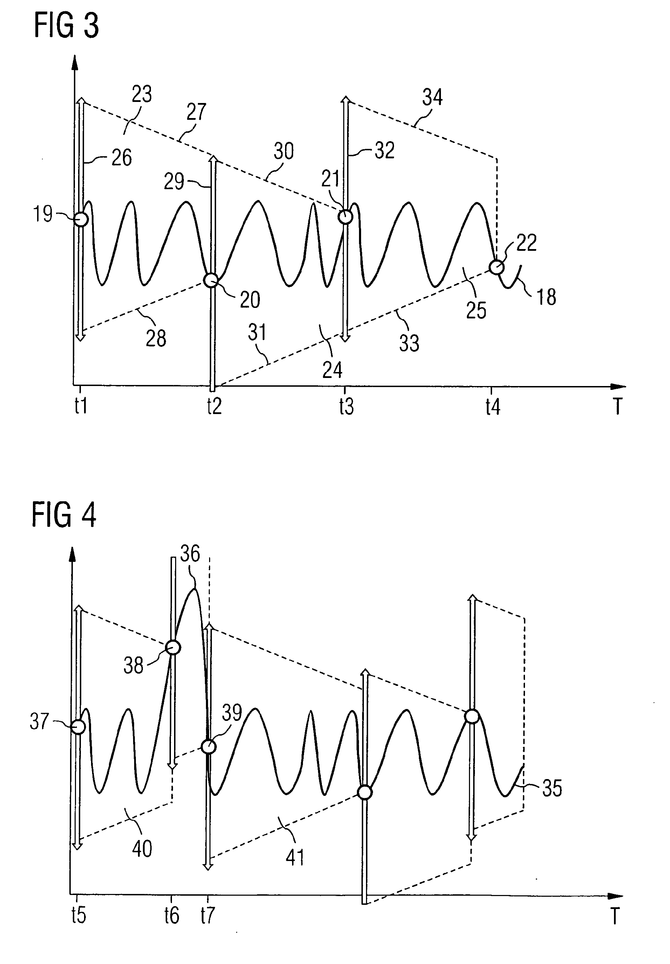

Erfindungsgemäß werden die Wertebereiche zum Abspeichern der Werte des Signals verändert. Die Wertebereiche sind somit variabel. Fig. 3 zeigt ein Ausführungsbeispiel des Erfassens von Werten eines Signals 18. Das Signal 18 ist ein stark verrauschtes, im Wesentlichen sinusförmiges Signal, dessen Verlauf in einem Koordinatensystem über der Zeit aufgetragen ist. Das Signal 18 wird mittels der Vorrichtung 11 abgetastet. Dabei werden Werte des Signals 18 erfasst, die an der Grenze oder außerhalb eines festgelegten, veränderlichen Wertebereichs liegen. Diese Werte werden in dem Datenspeicher 14 abgespeichert. In der Fig. 3 sind abgespeicherte Werte 19, 20, 21 und 22 mit einer runden Markierung versehen. Ferner sind in der Fig. 3 Wertebereiche 23, 24 und 25 dargestellt, die in ihrer zeitlichen Ausdehnung trapezförmige Flächen beschreiben, die mit Strich-Punkt-Linien gekennzeichnet sind. Die Größen der Wertebereiche 23-25 verändern sich in ihren jeweiligen zeitlichen Verläufen.

Der Wert 19 wird zu einem Zeitpunkt t1 des Verlaufs des Signals 18 erfasst und abgespeichert. Der Wert 19 dient als Ausgangspunkt für das in der Fig. 3 dargestellte Erfassen von Werten des Signals 18. Die Lage des Wertes 19 bestimmt die Lage des nachfolgenden Wertebereichs 23. Der Wertebereich 23 hat eine Anfangsgröße 26, die durch einen oberen Grenzwert 27 und einen unteren Grenzwert 28 festgelegt ist. Bei der Anfangsgröße 26 ist der obere Grenzwert 27 nach oben, d. h. in positiver Ordinatenrichtung, gleich weit von dem gespeicherten Wert 19 entfernt, wie der untere Grenzwert 28 nach unten, d. h. in negativer Ordinatenrichtung. In der Fig. 3 ist der Wertebereich 23 anfangs symmetrisch um den Wert 19 gelegt. Die Anfangsgröße 26 ist in der Fig. 3 durch einen vertikal in Ordinatenrichtung durch den Wert 19 verlaufenden Doppelpfeil verdeutlicht. Ausgehend von der Anfangsgröße 26 wird die Größe des Wertebereichs 23 dann verkleinert. Das Verkleinern erfolgt hier stetig nach einer vorgegebenen linearen Funktion. Der obere Grenzwert 27 wird im zeitlichen Verlauf nach einer linearen Funktion mit negativer Steigung erniedrigt und der untere Grenzwert 28 im zeitlichen Verlauf nach einer linearen Funktion mit positiver Steigung erhöht. Die Steigungen der beiden Funktionen sind dabei entgegengesetzt gleich. Die Veränderungen des oberen Grenzwerts 27 und des unteren Grenzwerts 28 erfolgen symmetrisch.

Durch das Verkleinern der Größe des Wertebereichs 23 trifft das Signal 18 zu einem Zeitpunkt t2 auf den unteren Grenzwert 28 des Wertebereichs 23. In dem Zeitpunkt t2 wird der Wert 20 des Signals 18 erfasst und abgespeichert. In dem Zeitbereich zwischen den Zeitpunkten t1 und t2 ist das Signal 18 kleiner als der jeweils eingestellte obere Grenzwert 27 und größer als der jeweils eingestellte untere Grenzwert 28. Es wird somit kein in diesem Zeitbereich liegender Wert des Signals 18 abgespeichert. Das Abspeichern des Wertes 20 bewirkt ein Festlegen des nächsten Wertebereichs 24. Der Wertebereich 24 nimmt hier zunächst eine Anfangsgröße 29 an, die der Anfangsgröße 26 entspricht. Nach dem Abspeichern eines neuen Wertes wird daher der zuvor verkleinerte Wertebereich wieder vergrößert. Insbesondere wird er wieder in eine ursprüngliche Anfangsgröße zurück versetzt. Die Lage des Wertes 20 bestimmt die Lage des Wertebereichs 24. Die Anfangsgröße 29 ist durch einen oberen Grenzwert 30 und einen unteren Grenzwert 31 festgelegt. Bei der Anfangsgröße 29 ist der obere Grenzwert 30 nach oben in positiver Ordinatenrichtung gleich weit von dem gespeicherten Wert 20 entfernt, wie der untere Grenzwert 31 nach unten in negativer Ordinatenrichtung. Der Wertebereich 24 ist anfangs symmetrisch um den Wert 20 gelegt. Die Anfangsgröße 29 ist durch einen vertikal in Ordinatenrichtung durch den Wert 20 verlaufenden Doppelpfeil verdeutlicht. Ausgehend von der Anfangsgröße 29 wird die Größe des Wertebereichs 24 dann verkleinert. Das Verkleinern erfolgt hier stetig nach einer vorgegebenen linearen Funktion. Das Verändern der Größe des Wertebereichs 24 erfolgt analog zum zuvor beschriebenen Verändern des Wertebereichs 23.

Durch das Verkleinern der Größe des Wertebereichs 24 trifft das Signal 18 zu einem Zeitpunkt t3 auf den oberen Grenzwert 30 des Wertebereichs 24. In dem Zeitpunkt t3 wird der Wert 21 erfasst und abgespeichert. In dem Zeitbereich zwischen den Zeitpunkten t2 und t3 ist das Signal 18 kleiner als der jeweils eingestellte obere Grenzwert 30 und größer als der jeweils eingestellte untere Grenzwert 31. Es wird somit kein in diesem Zeitbereich liegender Wert des Signals 18 abgespeichert. Das Abspeichern des Wertes 21 bewirkt ein Festlegen des nächsten Wertebereichs 25. Der Wertebereich 25 nimmt hier eine Anfangsgröße 32 an, die den Anfangsgrößen 26 und 29 entspricht. Wie zuvor im Zusammenhang mit den Wertebereichen 23 und 24 beschrieben, wird dann die Größe des Wertebereichs im zeitlichen Verlauf des Signals 18 stetig mit einer linearen Funktion verkleinert.

Dies erfolgt solange, bis das Signal 18 zu einem Zeitpunkt t4 auf einen unteren Grenzwert 33 des Wertebereichs 25 trifft. In dem Zeitpunkt t4 wird der Wert 22 erfasst und abgespeichert. In dem Zeitbereich zwischen den Zeitpunkten t3 und t4 ist das Signal 18 kleiner als ein jeweils eingestellter oberer Grenzwert 34 des Wertebereichs 25 und größer als der jeweils eingestellte untere Grenzwert 33. Es wird somit kein in diesem Zeitbereich liegender Wert des Signals 18 abgespeichert.

Durch das Verkleinern der Größen der Wertebereiche 23-25 kann die Menge an abzuspeichernden Werten bei dem stark verrauschten Signal 18 sehr gering gehalten werden. Gleichzeitig ist eine gute Abbildung des Rauschens mittels der abgespeicherten Werte sichergestellt.

Fig. 4 zeigt ein Ausführungsbeispiel des Erfassens von Werten in einem verrauschten Signal 35, das eine Signalspitze 36 aufweist. In der Fig. 4 sind, wie zuvor in der Fig. 3, mehrere Werte des Signals 35 mit runden Markierungen gekennzeichnet. Diese markierten Werte werden von dem Steuermittel 12 in dem Datenspeicher 14 abgespeichert. Beispielhaft sind in der Fig. 4 abgespeicherte Werte 37, 38 und 39 näher bezeichnet. Der Wert 37 wird zu einem Zeitpunkt t5 des Verlaufs des Signals 35 erfasst und abgespeichert. Der Wert 37 dient als Ausgangspunkt für das in der Fig. 4 dargestellte Erfassen von Werten des Signals 35. Die Lage des Wertes 37 bestimmt die Lage eines nachfolgenden Wertebereichs 40. Der Wertebereich 40 hat eine Anfangsgröße, die denjenigen der Wertebereiche 25-27 nach Fig. 3 entspricht und durch einen oberen Grenzwert und einen unteren Grenzwert festgelegt ist. Wie zuvor anhand der Fig. 3 beschrieben, wird die Größe des Wertebereichs 40 verkleinert.

In einem Zeitpunkt t6 trifft das Signal 35 auf den oberen Grenzwert des Wertebereichs 40. In dem Zeitpunkt t6 wird der Wert 38 erfasst und abgespeichert, den das Signal 35 zu diesem Zeitpunkt t6 aufweist. In dem Zeitbereich zwischen den Zeitpunkten t5 und t6 ist das Signal 35 kleiner als der jeweils eingestellte obere Grenzwert des Wertebereichs 40 und größer als dessen jeweils eingestellter unterer Grenzwert. Es wird somit kein in diesem Zeitbereich liegender Wert des Signals 35 abgespeichert.

Die Lage des Wertes 38 bestimmt die Lage eines nachfolgenden Wertebereichs 41. Der Wertebereich 41 hat eine Anfangsgröße, die derjenigen des Wertebereichs 40 entspricht und ebenfalls durch einen oberen Grenzwert und einen unteren Grenzwert festgelegt ist. Die Größe des Wertebereichs 41 wird, wie zuvor bei den anderen Wertebereichen, verkleinert. In seinem zeitlichen Verlauf um den Zeitpunkt t6 weist das Signal 35 einen schnellen und starken Anstieg bis zu der Signalspitze 36 auf. Die Signalspitze 36 stellt einen Wendepunkt im Signalverlauf dar, nach dem das Signal schnell abfällt. Dies führt dazu, dass das Signal 35 recht schnell auf den unteren Grenzwert des Wertebereichs 41 trifft. Dies erfolgt in einem Zeitpunkt t7. In dem Zeitpunkt t7 wird der Wert 39 erfasst und abgespeichert, den das Signal 35 zu diesem Zeitpunkt t7 hat. Die Lage des Wertes 38 bestimmt die Lage eines nachfolgenden Wertebereichs. Das weitere Erfassen und Abspeichern von Werten des Signals 35 erfolgt analog zu demjenigen nach Fig 3.

Der Zeitbereich zwischen den Zeitpunkten t6 und t7 ist sehr kurz, da das Signal 35 schnell abfällt. Erfindungsgemäß kann diese starke Signaländerung schnell erfasst werden. Dabei wird die Menge an abgespeicherten Werten gering gehalten und das Rauschen und die Signalspitze 36 des Signals 35 werden gut erfasst.

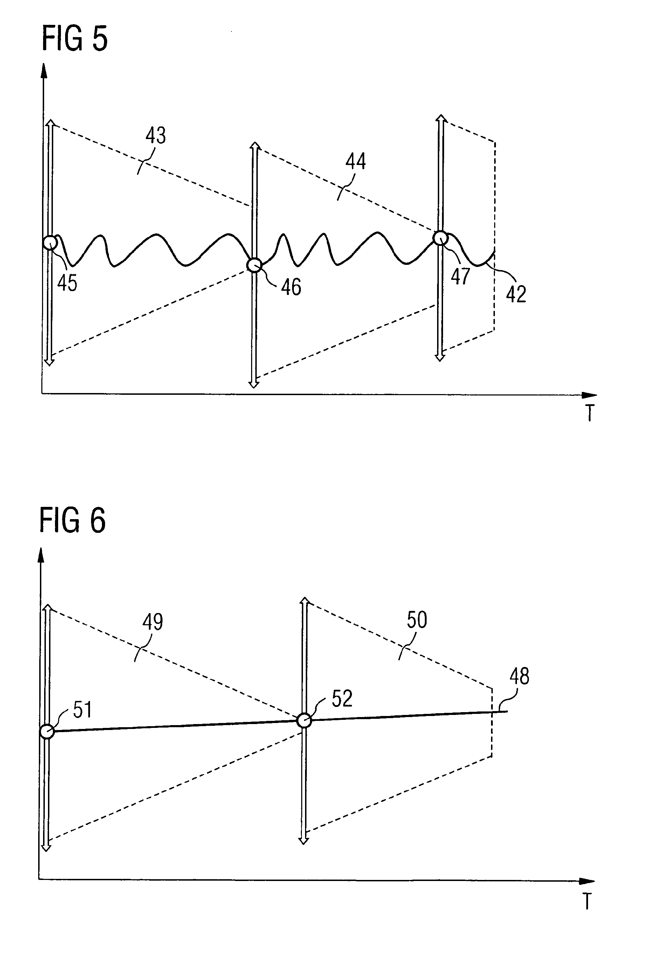

Fig. 5 zeigt ein Ausführungsbeispiel des Erfassens von Werten bei einem schwach verrauschten Signal 42. Durch das Verkleinern der Größen von festgelegten Wertebereichen 43 und 44 zum Erfassen von Werten des Signals 42 ist auch in diesem Fall gewährleistet, dass dieses geringe Rauschen genügend exakt mittels abgespeicherter Werte 45, 46 und 47 abgebildet wird.

Die Größen der Wertebereiche können bis zu einer vorgebbaren Minimalgröße verkleinert werden, die vorteilhafterweise der Größe Null entspricht. Die Größen der Wertebereiche können daher soweit verringert werden, dass ein Wertebereich überhaupt nicht mehr existiert. Dann wird, sofern noch ein Signal vorhanden ist, dessen Wert exakt festgestellt und abgespeichert. Wird die vorgegebene Minimalgröße eines Wertebereichs beim Verkleinern von dessen Größe erreicht, so steuert das Steuermittel 12 ein Abspeichern des dann vorhandenen Wertes des Signals.

Fig. 6 zeigt ein Ausführungsbeispiel des Erfassens von Werten bei einem schwach driftenden Signal 48. Das Signal 48 verläuft mit einer sehr geringen Steigung leicht ansteigend. Ähnlich dem Ausführungsbeispiel nach Fig. 5 ist durch das Verkleinern der Größen von festgelegten Wertebereichen 49 und 50 auch hier gewährleistet, dass diese schwache Drift des Signals 48 genügend exakt mittels abgespeicherter Werte 51 und 52 abgebildet wird. Die Größe des Wertebereichs 49 wird dazu besonders stark verkleinert, bis das Signal 48 auf einen, ausgehend von seiner Anfangsgröße, bereits stark verkleinerter oberer Grenzwert des Wertebereichs 49 trifft. Der dann vorhandene Wert 52 des Signals 48 wird abgespeichert.

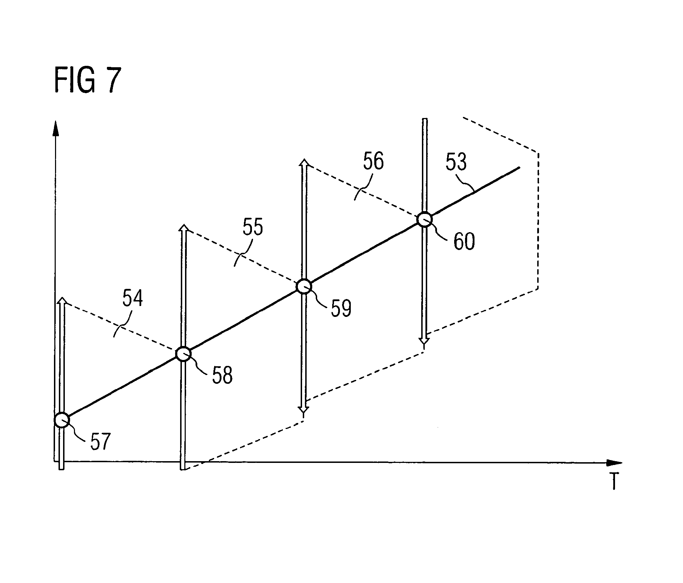

Fig. 7 zeigt ein Ausführungsbeispiel des Erfassens von Werten bei einer starken Änderung eines Signals 53. Das Signal 53 ist ein mit einer großen Steigung ansteigendes, stark driftendes Signal. Das Verkleinern der Größen von festgelegten Wertebereichen 54, 55 und 56 gewährleistet, dass dieses starke Driften des Signals 53 schnell erfasst und mittels abgespeicherter Werte 57, 58, 59 und 60 abgebildet wird. Bei den Werten 57-60 trifft das Signal 53 jeweils auf einen oberen Grenzwert der Wertebereiche 54-56.

In den vorangehend beschriebenen Ausführungsbeispielen werden die Größen der Wertebereiche mittels einer linearen Funktion verändert. Es ist ebenso möglich, die Veränderung in anderer, geeigneter Weise durchzuführen. Beispielsweise kann die Veränderung auch mittels einer exponentiellen Funktion erfolgen. Des Weiteren erfolgen in den beschriebenen Ausführungsbeispielen die Veränderungen der oberen Grenzwerte und der unteren Grenzwerte der jeweiligen Wertebereiche symmetrisch. Es ist hier ebenso möglich, die Veränderungen in anderer, geeigneter Weise durchzuführen, so dass sie nicht entgegengerichtet gleich sind. Ferner werden insbesondere die Lagen der jeweiligen Wertebereiche in Abhängigkeit von unmittelbar zuvor abgespeicherten Werten des Signals festgelegt. Es ist jedoch auch möglich, die Wertebereiche in Abhängigkeit von prognostizierten, zukünftigen Werten festzulegen, die aufgrund von zuvor erfassten Werten des Signals bestimmt werden, durch die die Struktur des Signals abgebildet wird.

## Patentansprüche

1. Verfahren zum Erfassen von Werten (19-22; 37-39; 45-47; 51, 52; 57-60) eines Signals (18; 35; 42; 48; 53), bei dem ein Wert (19-22; 37-39; 45-47; 51, 52; 57-60) des Signals (18; 35; 42; 48; 53) gespeichert wird, wenn der Wert (19-22; 37-39; 45-47; 51, 52; 57-60) außerhalb oder an der Grenze eines vorgegebenen Wertebereichs (23-25; 40, 41; 43, 44; 49, 50; 54-56) liegt, dessen Größe durch einen oberen Grenzwert (27, 30, 34) und einen unteren Grenzwert (28, 31, 33) bestimmt ist, **dadurch gekennzeichnet, dass** die Größe des Wertebereichs (23-25; 40, 41; 43, 44; 49, 50; 54-56) ausgehend von einer vorgegebenen Anfangsgröße (26, 29, 32) des Wertebereichs (23-25; 40, 41; 43, 44; 49, 50; 54-56) während des Erfassens der Werte (19-22; 37-39; 45-47; 51, 52; 57-60) verändert wird.

2. Verfahren nach Anspruch 1, **dadurch gekennzeichnet, dass** die Größe des Wertebereichs (23-25; 40, 41; 43, 44; 49, 50; 54-56) nach einer Veränderung erneut die Anfangsgröße (26, 29, 32) annimmt, wenn ein Wert (19-22; 37-39; 45-47; 51, 52; 57-60) abgespeichert wurde.

3. Verfahren nach Anspruch 1 oder 2, **dadurch gekennzeichnet, dass** die Größe des Wertebereichs (23-25; 40, 41; 43, 44; 49, 50; 54-56), insbesondere stetig, verkleinert wird.

4. Verfahren nach Anspruch 3, **dadurch gekennzeichnet, dass** ein Wert (19-22; 37-39; 45-47; 51, 52; 57-60) auch dann gespeichert wird, wenn beim Verkleinern des Wertebereichs (23-25; 40, 41; 43, 44; 49, 50; 54-56) eine vorgegebene Minimalgröße des Wertebereichs (23-25; 40, 41; 43, 44; 49, 50; 54-56) erreicht wird und noch kein außerhalb oder an der Grenze des verkleinerten Wertebereichs (23-25; 40, 41; 43, 44; 49, 50; 54-56) liegender Wert (19-22; 37-39; 45-47; 51, 52; 57-60) des Signals (18; 35; 42; 48; 53) erfasst wurde.

5. Verfahren nach Anspruch 4, **dadurch gekennzeichnet, dass** die vorgegebene Minimalgröße des Wertebereichs (23-25; 40, 41; 43, 44; 49, 50; 54-56) Null beträgt.

6. Verfahren nach einem der vorhergehenden Ansprüche, **dadurch gekennzeichnet, dass** beim Verändern der Größe des Wertebereichs (23-25; 40, 41; 43, 44; 49, 50; 54-56) ein symmetrisches Ändern des oberen Grenzwerts (27, 30, 34) und des unteren Grenzwerts (28, 31, 33) erfolgt.

7. Verfahren nach einem der vorhergehenden Ansprüche, **dadurch gekennzeichnet, dass** das Verändern der Größe des Wertebereichs (23-25; 40, 41; 43, 44; 49, 50; 54-56) nach einer linearen Funktion erfolgt.

8. Verfahren nach einem der vorhergehenden Ansprüche, **dadurch gekennzeichnet, dass** der Wertebereich (23-25; 40, 41; 43, 44; 49, 50; 54-56) in Abhängigkeit von einem, insbesondere unmittelbar, zuvor abgespeicherten Wert (19-22; 37-39; 45-47; 51, 52; 57-60) des Signals (18; 35; 42; 48; 53) festgelegt wird.

9. Verfahren nach einem der vorhergehenden Ansprüche, **dadurch gekennzeichnet, dass** der Wertebereich (23-25; 40, 41; 43, 44; 49, 50; 54-56) in Abhängigkeit von einem prognostizierten Wert festgelegt wird, der aufgrund der bisher erfassten Werte (19-22; 37-39; 45-47; 51, 52; 57-60) des Signals (18; 35; 42; 48; 53) bestimmt wird.

10. Verfahren nach einem der vorhergehenden Ansprüche, **dadurch gekennzeichnet, dass** eine insbesondere maximale Anzahl von in einem vorgegebenen ersten Zeitbereich des Signals (18; 35; 42; 48; 53) zu speichernden Werten (19-22; 37-39; 45-47; 51, 52; 57-60) vorgegeben ist.

11. Verfahren nach einem der vorhergehenden Ansprüche, **dadurch gekennzeichnet, dass** die Anfangsgröße (26, 29, 32) des Wertebereichs (23-25; 40, 41; 43, 44; 49, 50; 54-56) in Abhängigkeit von während eines vorgegebenen zweiten Zeitbereichs des Signals (18; 35; 42; 48; 53) abgespeicherten Werten (19-22; 37-39; 45-47; 51, 52; 57-60) festgelegt wird.

12. Vorrichtung (11) zum Erfassen von Werten (19-22; 37-39; 45-47; 51, 52; 57-60) eines Signals (18; 35; 42; 48; 53), wobei die Vorrichtung (11) ein Steuermittel (12) aufweist, dass so ausgestaltet ist, dass es einen Wert (19-22; 37-39; 45-47; 51, 52; 57-60) des Signals (18; 35; 42; 48; 53) abspeichert, wenn der Wert (19-22; 37-39; 45-47; 51, 52; 57-60) außerhalb oder an der Grenze eines vorgegebenen Wertebereichs (23-25; 40, 41; 43, 44; 49, 50; 54-56) liegt, dessen Größe durch einen oberen Grenzwert (27, 30, 34) und einen unteren Grenzwert (28, 31, 33) bestimmt ist, **dadurch gekennzeichnet, dass** das Steuermittel (12) ferner so ausgestaltet ist, dass es die Größe des Wertebereichs (23-25; 40, 41; 43, 44; 49, 50; 54-56) während des Erfassens der Werte (19-22; 37-39; 45-47; 51, 52; 57-60) ausgehend von einer vorgegebenen Anfangsgröße (26, 29, 32) verändert.
